(19) Europäisches Patentamt
European Patent Office
Office européen des brevets

(11) **EP 3 780 064 B1**

(12) **EUROPÄISCHE PATENTSCHRIFT**

(45) Veröffentlichungstag und Bekanntmachung des Hinweises auf die Patenterteilung:
**22.06.2022 Patentblatt 2022/25**

(21) Anmeldenummer: **20186011.1**

(22) Anmeldetag: **15.07.2020**

(51) Internationale Patentklassifikation (IPC):
***H01J 37/153*** *(2006.01)*

(52) Gemeinsame Patentklassifikation (CPC):
**H01J 37/153;** H01J 2237/1534

(54) **TEILCHENOPTISCHER KORREKTOR FREI VON AXIALEN FEHLERN SECHSTER ORDNUNG UND ELEKTRONENMIKROSKOP MIT KORREKTOR**

PARTICLE OPTICAL CORRECTOR FREE OF AXIAL ERRORS OF SIXTH ORDER AND ELECTRON MICROSCOPE WITH CORRECTOR

CORRECTEUR OPTIQUE À PARTICULES SANS ERREURS AXIALES DE SIXIÈME ORDRE ET MICROSCOPE ÉLECTRONIQUE POURVU D'UN CORRECTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.08.2019 DE 102019122013**

(43) Veröffentlichungstag der Anmeldung:
**17.02.2021 Patentblatt 2021/07**

(73) Patentinhaber: **Ceos Corrected Electron Optical Systems GmbH**
**69126 Heidelberg (DE)**

(72) Erfinder: **Uhlemann, Dr., Stephan**
**69115 Heidelberg (DE)**

(74) Vertreter: **Weber & Seidel**
**Rechts- und Patentanwälte**
**Handschuhsheimer Landstraße 2a**
**69120 Heidelberg (DE)**

(56) Entgegenhaltungen:
**EP-A1- 2 325 862      DE-A1-102006 017 686**
**US-A1- 2008 265 172**

• **SAWADA H ET AL: "Correction of higher order geometric aberration by tripple 3-fold astigmatism field", JOURNAL OF ELECTRON MICROSCOPY, JAPANESE SOCIETY FOR ELECTRON MICROSCOPY. TOKYO, JP, Bd. 58, Nr. 6, 1. Juni 2009 (2009-06-01), Seiten 341-347, XP009134702, ISSN: 0022-0744 [gefunden am 2009-07-08]**

**Beschreibung**

Die Erfindung betrifft einen teilchenoptischen Korrektor zum Korrigieren der Öffnungsfehler eines Elektronenmikroskops unter Vermeidung des dreizähligen axialen Astigmatismus, des axialen Dreilappfehlers vierter Ordnung und des sechszähligen axialen Astigmatismus, wobei der Korrektor ein zentrales Multipolelement der Länge $L$ zur Erzeugung eines Hexapolfeldes in der Symmetrieebene des Korrektors sowie zwei äußere identische Multipolelemente der Länge $L'$ zur Erzeugung gleich starker Hexapolfelder und zwei Rundlinsendupletts mit Rundlinsen aufweist, wobei die zur Symmetrieebene näheren Rundlinsen zur Symmetrieebene im Abstand der Brennweiten der Rundlinsen angeordnet sind, und die zur Symmetrieebene weiter entfernten Rundlinsen von letzteren einen Abstand aufweisen, der ihren Brennweiten zuzüglich der Brennweiten der Rundlinsen, die näher zur Symmetrieebene liegen, entspricht.

Elektronenoptische Abbildungssysteme werden sowohl zur Vergrößerung, wie im Fall der Elektronenmikroskopie, als auch zur Verkleinerung in der Elektronenprojektionslithographie eingesetzt. Der Vorteil gegenüber lichtoptischen Abbildungssystemen ist ihr wesentlich höheres Auflösungsvermögen, das sich aus der wesentlich geringeren Wellenlänge der abbildenden optischen Strahlung ergibt. Gegenüber Licht erbringen elektronenoptische Abbildungssysteme in Abhängigkeit von der Beschleunigungsspannung eine Verbesserung der Auflösung um einen Faktor von ca. $10^4$, so daß Abbildungen bis in den Atombereich möglich sind.

Die Führung von Elektronenstrahlen zum Zwecke der Abbildung erfolgt mit Hilfe elektrischer und/oder magnetischer Linsen. Derartige Linsensysteme sind in Abhängigkeit von ihrem Aufbau und ihrer Anordnung in höherem Maße als lichtoptische Systeme mit unterschiedlichen Bildfehlern behaftet.

Der Zweck teilchenoptischer Korrektoren besteht darin, Öffnungs- und gegebenenfalls Farbfehler der optischen Bauteile des Mikroskops zu kompensieren. Durch die Kompensation mittels solcher Korrektoren werden aber auch Fehler vom Korrektor selbst verursacht.

Bei diesen Fehlern handelt es sich zum einen um parasitäre Fehler, resultierend aus Material- und Dimensionierungsfehlern sowie Justierfehlern. Zum anderen gibt es intrinsische residuale Fehler, diese sind physikalisch bedingt, das heißt, sie würden auch bei einer bautechnisch fehlerlosen Teilchenoptik auftreten. Letztere müssen in Kauf genommen werden, um den primären Zweck der Korrektur der abbildenden Linsen erreichen zu können. Für die mit Hilfe der Korrektur beste erreichbare optische Qualität der Abbildung ist es notwendig, diese residualen Fehler zu minimieren oder besser weitgehend zu vermeiden.

Unter den Fehlern gibt es chromatische und geometrische Fehler. Die geometrischen Fehler werden nach Bildfehlerfiguren eingeteilt, welche in verschiedenen Ordnungen auftreten, dabei ist eine Klassifizierung nach der Seidel-Ordnung üblich. Eine Aufstellung solcher Fehler findet sich in Rolf Erni, "Aberration-Corrected Imaging in Transmission Electron Microscopy - An Introduction", 2010, Seiten 222, 224 und 225, einschließlich einer Tabelle abweichender Fehlernomenklaturen auf Seite 225.

Die Grundlage für die Funktion aller Korrektoren in der Teilchenoptik bildet die Erkenntnis von O. Scherzer (O. Scherzer: "Sphärische und chromatische Korrektur von Elektronen-Linsen" OPTIK, DE, JENA, 1947, Seiten 114-132, XP002090897, ISSN: 0863-0259), daß für Teilchenoptiken die Korrektur von Farb- und Öffnungsfehlern möglich ist, wenn man mittels Multipolen nicht rotationssymmetrische Felder erzeugt, um einen unrunden Strahl zu formen, an diesem die Fehlerkorrektur vornimmt und durch entgegengesetzt wirkende Felder den Strahl wieder rund macht.

Die Fehlerkorrektur läuft darauf hinaus, daß der Korrektor Fehler erzeugt, die den Fehlern des optischen Systems entgegengesetzt sind und diese dadurch kompensieren. Allerdings ist es so, daß solche Korrektoren auch selbst wieder Fehler erzeugen, welche soweit wie möglich innerhalb des Korrektors ebenfalls kompensiert werden müssen.

Die geometrischen Fehler deformieren die Wellenfronten des Lichts bzw. in der Teilchenoptik der Teilchenstrahlen in eine nicht sphärische Form, wobei der Korrektor diese Form in möglichst hohem Maß wieder herstellen muß oder derart deformieren muß, daß sie nach dem Auftreten nachfolgender Fehler wieder sphärisch wird. Bezüglich der Grundzüge dieser Korrektur der Wellenfronten wird auf Rolf Erni (a.a.O., Seiten 214 - 228, Kapitel "7.5 Wave Surface, Aberration Funktion and Image Aberrations") verwiesen.

Das Ganze dient dazu, hochaufgelöste Bilder dünner Schichten innerhalb einer Probe zu erzielen - letztlich eine optimale Einstellung des Mikroskops. Dies wird um so mehr erreicht, je höher die Ordnung der Fehler ist, bis zu der alle Fehlerordnungen kompensiert sind. Das Problem dabei ist jedoch, daß in der Praxis - im Gegensatz zur Theorie, die sich berechnen läßt -jede weitere Fehlerkorrektur wieder Rückwirkungen auf bereits kompensierte Fehler hat, die dann wieder auftauchen und erneut kompensiert werden müssen. Dadurch muß man sich einer optimalen Fehlerkorrektur in einer iterativen Systematik annähern. In der Praxis ist es somit nicht möglich, alle Fehler bis zu einer bestimmten Ordnung restlos zu beseitigen, aber sie soweit zu vermindern, daß sie die gewünschte Bildqualität bezüglich Auflösung und Schärfe nicht mehr ergebnisrelevant beeinflussen. Das Ziel ist also theoretisch zwar absolut, in der Praxis geht es jedoch um die Verfügbarkeit der Bildqualität für den jeweiligen Einsatzzweck, dem ein Elektronenmikroskop dient. Wenn man also von der Beseitigung oder Korrektur eines Fehlers spricht, so ist das in diesem Sinne gemeint.

Bekannt sind Öffnungsfehlerkorrektoren, die residuale axiale Fehler bis zur fünften Ordnung vermeiden. Wenn aber bei diesen Korrektoren die Fehler bis zur fünften Ordnung korrigiert sind, wird ein Dreilappfehler sechster Ordnung derart dominant, daß dieser in nicht akzeptabler Weise die Bildqualität stört, wenn man die Objektivapertur weiter öffnet. Bei den bekannten Korrektoren handelt es sich um solche mit zwei oder drei Hexapolen mit zwischengeordneten Rundlinsendupletts.

Bei den Korrektoren mit zwei Hexapolen handelt es sich um den Korrektor EP 0 451 370 B1 (Rose) sowie Weiterentwicklungen dieses Korrektors, beispielsweise Müller H., Uhlemann S., Hartel P., and Haider M. (2006) "Advancing the Hexapole Cs-corrector for the scanning transmission electron microscope." Microsc. Microanal. 12: 442 - 455. Ein Korrektor mit drei Hexapolen ist beispielsweise der aus der EP 3 255 649 A1 oder aus der DE 10 2006 017 686 A1 bekannt. Weiterhin bekannt ist der Deltakorrektor (Sawada et. al. "Correction of higher order geometrical aberration by triple 3-fold astigmatism field", Journal of Electron Microscopy 58(6): 341 - 347 (2009)).

In der EP 3 255 649 A1 (Morishita) wird vorgeschlagen, daß der axiale Dreilappfehler sechster Ordnung gemessen wird, um dann mittels der Fehler des dreizähligen axialen Astigmatismus ($A_2$) und des axialen Dreilappfehlers vierter Ordnung ($D_4$) die durch den Dreilappfehler sechster Ordnung ($D_6$) verursachten Phasenschwankungen zu reduzieren. Damit ist jedoch der axiale Dreilappfehler sechster Ordnung nicht weg, sondern lediglich die Phasenabweichung verbessert, es handelt sich also um keine Fehlerkorrektur, sondern lediglich um eine Optimierung.

Mit der Frage, ob sich mit diesen Korrektoren mit zwei oder drei Hexapolen der Dreilappfehler sechster Ordnung beseitigen läßt, setzt sich die Abhandlung von Morishita et.al. "Evaluation of residual aberration in fifth-order geometrical aberration correctors" (Mircroscopy, 2018, 156-163) auseinander. In dieser Abhandlung kommt man zu dem Schluß, daß der Dreilappfehler sechster Ordnung ($D_6$ - dort als $R_7$ bezeichnet) weder bei den Korrektoren mit zwei Hexapolen, noch bei solchen mit drei Hexapolen, wie dem Deltakorrektor, vermieden werden kann.

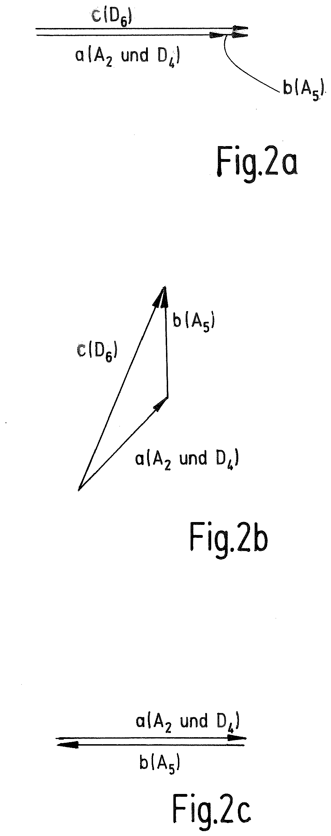

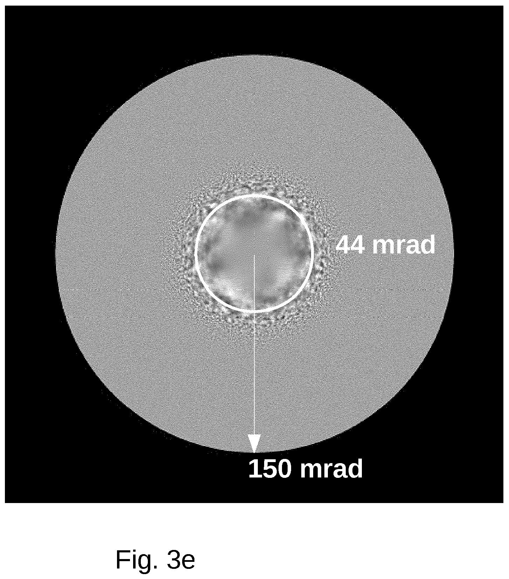

In der EP 2 325 862 A1 und der EP 2 325 863 B1 (jeweils Henstra) wird ausgehend vom oben genannten Rose-Korrektor mit zwei Hexapolen vorgeschlagen, in das Rundlinsenduplett zwischen den zwei Hexapolen einen zusätzlichen Hexapol mit einem schwachen Hexapolfeld einzufügen. Mit diesem schwachen Hexapolfeld läßt sich dann entweder der sechszählige Astigmatismus fünfter Ordnung ($A_5$) oder der Dreilappfehler sechster Ordnung ($D_6$) korrigieren (siehe jeweils Anspruch 1). In beiden Schriften (EP 2 325 862 A1 unter [0071] und in der EP 2 325 863 B1 unter [0074] wird die Idee geäußert, daß zusammen mit einem Zwölfpol, der dem Korrektor in Richtung der Objektivlinse vor einem Transferlinsendublett nachgeordnet ist (Fig. 2, Bezugszeichen 128), sowohl der sechszählige Astigmatismus fünfter Ordnung ($A_5$) als auch der Dreilappfehler sechster Ordnung ($D_6$) gleichzeitig korrigiert werden können. Die Theorie ist zwar richtig, die praktische Realisierung scheitert jedoch an zwei Tatsachen: Um den gewünschten Effekt zu erzielen, müßte das Zwölfpolfeld eine Stärke aufweisen, wie sie in praktischen technischen Ausführungen nicht realisierbar ist. Zum anderen entsteht bei dieser Anordnung ein residualer Kranzfehler ($G_7$), der in seiner Wirkung sogar größer ist als der beseitigte Dreilappfehler sechster Ordnung ($D_6$) und somit den Zweck einer Verbesserung völlig verfehlt (siehe Fig. 3e).

Der Deltakorrektor (siehe oben) ist ein Korrektor der eingangs genannten Art, mit dem sich der Öffnungsfehler ($C_s$) unter Vermeidung des axialen Astigmatismus ($A_2$), des axialen Dreilappfehlers vierter Ordnung ($D_4$) und des sechszähligen axialen Astigmatismus ($A_5$) korrigieren läßt, jedoch nicht der Dreilappfehler sechster Ordnung ($D_6$). Dies wurde von Morishita et. al. (siehe oben) sowohl rechnerisch als auch experimentell untersucht und das Ergebnis auf Seite 162 (links oben) zusammengefaßt (a.a.O.).

Der Erfindung liegt daher die Aufgabe zugrunde, einen Öffnungsfehlerkorrektor verfügbar zu machen, der alle unrunden axialen Fehler bis zur fünften Ordnung und den Dreilappfehler sechster Ordnung vermeidet, ohne Fehler einzuführen, welche die dadurch erzielte Verbesserung wieder zunichte machen.

Die Aufgabe wird bei einem teilchenoptischen Korrektor der eingangs genannten Art dadurch gelöst, daß die Stärke des zentralen Hexapolfeldes zu den Stärken der beiden gleich starken äußeren Hexapolfelder derart gewählt ist, daß der dreizählige axiale Astigmatismus verschwindet und die Stärken letzterer so gewählt sind, daß der Korrektor insgesamt keinen sechszähligen axialen Astigmatismus hat, daß der Abstand der Multipolelemente von den der Symmetrieebene weiter entfernten Rundlinsen, deren Brennweite zuzüglich eines weiteren Abstandes entspricht, wobei letzterer so gewählt ist, daß für die gegebenen Längen des zentralen Multipolelements und der gegebenen Längen der identischen Multipolelemente der axiale Dreilappfehler vierter Ordnung verschwindet, und daß die Länge des zentralen Multipolelements im Verhältnis zu den Längen der zwei äußeren identischen Multipolelemente derart gewählt ist, daß der axiale Dreilappfehler sechster Ordnung - für das vorgegebene Verhältnis der Brennweite der zur Symmetrieebene näheren Rundlinsen zu der Brennweite der zur Symmetrieebene weiter entfernten Rundlinsen - verschwindet.

Der Ausgangspunkt der Erfindung besteht darin, daß sich die internen Kombinationsfehler des dreizähligen axialen Astigmatismus ($A_2$) und des axialen Dreilappfehlers vierter Ordnung ($D_4$) mit dem Hexapolfeld einerseits und des sechszähligen axialen Astigmatismus ($A_5$) mit dem Hexapolfeld andererseits gegenseitig eliminieren müssen. Dies ist so zu verstehen, daß der Strahl durch ein Hexapolfeld zuerst deformiert wird und dann durch ein nachfolgendes Hexapolfeld wieder rund gemacht wird. Im unrunden Strahlbereich werden einerseits unerwünschte schon vorhandene Fehler beseitigt, andererseits für eine Kompensation nachfolgender Fehler dieselben Fehler mit umgekehrtem Vorzeichen für die nachfolgende Kompensation erzeugt. Bei den Multipolelementen der Erfindung findet diese Deformierung und das Wieder-rund-machen folgendermaßen statt: Der Strahl tritt in das erste Multipolelement ein, wird dort deformiert und in der ersten Hälfte (vor der Symmetrieebene) des zentralen Multipolelements nach einer Fehlerkompensation der vorgenannten Art wieder rund gemacht. In der zweiten Hälfte des zentralen Multipolelements (nach der Symmetrieebene) wird der Strahl nochmals deformiert, um dann im zweiten Multipolelement, das mit dem ersten identisch ist, wieder rund gemacht zu werden. Auch dort werden im unrunden Strahlenbereich Fehler kompensiert.

Die oben genannten Kombinationsfehler ergeben im Hexapolfeld durch Vektoren in einer zweidimensionalen Ebene darstellbare Fehlerbeiträge, nämlich $a \hat{=} D_4 + A_2$ mit Hexapolfeld und $b \hat{=} A_5$ mit Hexapolfeld. Ohne die Erfindung bilden diese Vektoren a und b ein Dreieck, wobei die dritte Seite c des Dreiecks der Vektor des resultierenden axialen Dreilappfehlers sechster Ordnung ($D_6$) ist. In der bekannten Literatur (z. B. Morishita et. al. - siehe oben) wirken diese teilweise in die gleiche Richtung, so daß die Resultante c betragsgemäß größer als a und b alleine ist. Ziel der Erfindung ist es, daß die beiden Vektoren a und b parallel gegeneinander gerichtet sind und damit der axiale Dreilappfehler sechster Ordnung ($D_6$) zu Null gebracht wird.

Dabei ist es das weitere Ziel, den Strahl mit dieser Fehlerfreiheit mit möglichst großem Aperturwinkel ($\alpha$) in die Probe zu fokussieren, um die Beugungsbegrenzung gering zu halten. Maß für die Beugungsbegrenzung ist $\lambda / \alpha$. Bei der Lichtoptik ist der Winkel $\alpha$ viel größer als bei der Elektronenmikroskopie. Daß aber letztere eine viel geringere Beugungsbegrenzung hat, liegt daran, daß die Wellenlänge $\lambda$ bei Elektronenstrahlen viel geringer ist als bei Lichtwellen.

Bei der Erfindung sind vier Verhältnisse ausschlaggebend:
Zum einen das Verhältnis der Hexapolstärken, also der Stärke des zentralen Multipols ($\Psi_{HP2}$) zu den Stärken ($\Psi_{HP1,3}$) der beiden anderen äußeren identischen Multipolelemente. (Zur Erzeugung der Hexapolfelder können Hexapolelemente oder Multipolelemente mit mehr Polen eingesetzt werden.)

Zum anderen müssen die Stärken der äußeren Hexapolfelder so gewählt sein, daß der Korrektor insgesamt keinen sechszähligen axialen Astigmatismus hat.

Weiterhin ist das Verhältnis d des Maßes des weiteren Abstands der Mittelebenen der äußeren identischen Hexapole zu den Brennebenen der äußeren Transferlinsen (7", 8") $\Delta z$ zur Länge $L'$ der äußeren identischen Multipolelemente (1, 3) relevant.

Außerdem das Verhältnis der Länge $L$ des zentralen Multipolelements 2 zur Länge $L'$ der zwei äußeren identischen Multipolelemente 1 und 3.

Zum Verhältnis der Hexapolstärken $\Psi_{HP2}$ zu $\Psi_{HP1,3}$:
Die Stärke der Hexapolfelder $\Psi$ ergibt sich aus der Windungszahl N multipliziert mit der Stromstärke I, außerdem ist noch der Radius R der Bohrung nach folgender Formel relevant: Stärke des Hexapols:

$$\Psi = \mu_0 \cdot N \cdot I \cdot R^{-3}$$

Permeabilität des Vakuums:

$$\mu_0 = 4\pi \cdot 10^{-7} \, \mathrm{As/Vm}$$

Das erforderliche Stärkeverhältnis des zentralen Hexapolfeldes $\Psi_{HP1}$ zu der Stärke der beiden anderen identischen Hexapolfelder $\Psi_{HP2,3}$ wird durch folgende Formel wiedergegeben, welche zur Freiheit vom dreizähligen axialen Astigmatismus ($A_2$) führt:

$$\frac{\Psi_{HP2}}{\Psi_{HP1,3}} = \frac{2}{k \cdot M^3}$$

Dabei ist $k$ das Verhältnis der Länge $L$ des zentralen Multipolelements (2) zu den Längen $L'$ der beiden anderen identischen Multipolelemente (1, 3), also

$$k = L \ / \ L'$$

$M$ ist das Verhältnis der Brennweiten $f$ der näher zur Symmetrieebene liegenden Rundlinsen (7', 8') zu den Brennweiten $f$ der weiter weg liegenden (7", 8"), also

$$M = f \ / \ f'$$

Zu den Stärken ($\Psi_{HP1,3}$) der äußern Hexapolfelder:
Diese müssen so gewählt sein, daß der Korrektor insgesamt keinen sechszähligen axialen Astigmatismus ($A_5$) hat. Mit diesem Problem hat sich schon die oben genannte Veröffentlichung Müller et.al. (2006) beschäftigt, wobei es sich bei diesem Korrektor um einen Zweihexapolkorrektor handelte, bei dem die x-Komponente des $A_5$-Fehlers ($A_{5x}$) beseitigt wurde, jedoch noch eine geringe y-Komponente des Fehlers $A_5$, also ein $A_{5y}$ übrigbleibt. Da es sich bei der Erfindung jedoch um einen Dreihexapolkorrektor handelt, verschwindet dieses $A_{5y}$ aus Symmetriegründen.

Zum Maß des weiteren Abstandes $\Delta z$:
Dies ist die Verschiebung der Mittelebenen der beiden identischen äußeren Multipole zusätzlich zur Entfernung der Brennweite $f$ der äußeren Rundlinsen (7" und 8"), also von den Brennpunkten nach außen.

Für das Verhältnis d des Maßes $\Delta z$ zur Länge L' der beiden identischen Multipolelemente (1 und 2) gilt*:

$$d = \frac{\Delta z}{L'} = \frac{10k - \sqrt{5} \cdot \sqrt{9M^4 - k^2}}{30M^2}$$

Damit muß etwa gelten:

$$\Delta z = d \bullet L'$$

Damit verschwindet der Dreilappfehler vierter Ordnung ($D_4$). $k$ und $M$ sind schon oben definiert. Bei dieser Formel* handelt es sich um eine Näherungsformel, da sie von der Annahme eines kastenförmigen Hexapolfeldes ausgeht (real quillt das Hexapolfeld etwas über die Länge $L$ bzw. $L'$ hinaus).

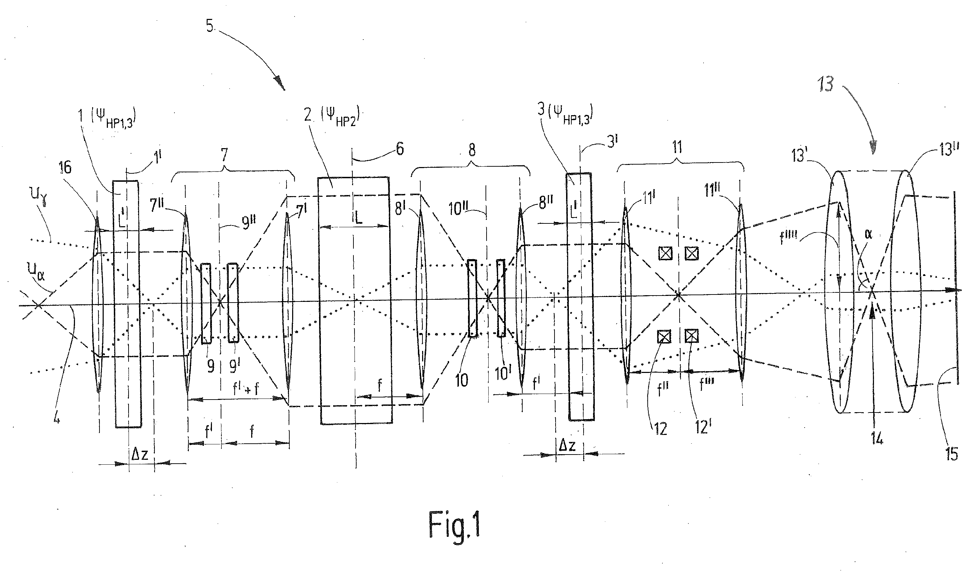

Erfindungsgemäß muß auch dieses Merkmal der Freiheit vom Dreilappfehler vierter Ordnung ($D_4$) erfüllt sein. Beim Deltakorrektor ist dieses Verhältnis anders, dort ist d = 0 und somit $\Delta z$ = 0. Die beiden äußeren Hexapolfelder liegen beim Deltakorrektor in den Brennweiten der - im Vergleich zur Symmetrieebene - äußeren Rundlinsen, dafür sind die äußeren Hexapolelemente zur Erfüllung der Freiheit vom axialen Dreilappfehler vierter Ordnung ($D_4$) gegeneinander verdreht (siehe die oben genannte Abhandlung von Morishita et. al., dort S. 158, Fig. 1b).

Zum Verhältnis der Länge $L$ des zentralen Multipolelements 2 zu den Längen $L'$ der äußeren identischen Multipolelemente 1 und 3:
Hier geht es um die Bedingung dafür, daß sich die beiden Vektoren a und b gegenseitig aufheben, also die in allen Hexapolfeldern entstehenden Fehler $A_2$ und $D_4$ nachfolgend in diesen Hexapolfeldern einen Kombinationsfehler $D_6$ erzeugen, der durch den entgegengerichteten Kombinationsfehler $D_6$ im zentralen Hexapolfeld, verursacht durch den Fehler $A_5$, aufgehoben wird. Erreicht wird diese Aufhebung durch die Wahl der Länge $L$ des zentralen Multipolelements 2 zu den Längen $L'$ der identischen Multipolelementen 1 und 3.

Für den (im Falle der Erfindung näherungsweise reellen) Vektor a läßt sich dies mit folgender Formel beschreiben:

$$\Delta D_{6x}^{(a)} = 3 \int \Psi(z) \cdot X_{\langle A2 \rangle}(z) \cdot X_{\langle D4 \rangle}(z) \cdot u_\alpha(z) \; dz$$

Und für den Vektor b:

$$\Delta D_{6x}^{(b)} = 3 \int_{HP2} \Psi(z) \cdot X_{\langle A5 \rangle}(z) \cdot u_\alpha^2(z) \; dz$$

Dabei sind $X_{\langle A2 \rangle}$, $X_{\langle D4 \rangle}$ und $X_{\langle A5 \rangle}$ die Fehlerbahnen der Fehler $A_2$, $D_4$ und $A_5$ und $u_\alpha$ ist die axiale Fundamentalbahn, die von der Strahlenquelle kommt und durch die Objektivlinse in die Objektebene fokussiert wird. Die y-Komponenten der Vektoren sind aufgrund der identischen Orientierung der Hexapole (im Gegensatz zum Deltakorrektor) vernachlässigbar.

Letztlich sind die vorgenannten drei Verhältnisse - wie schon aus den Formeln ersichtlich - miteinander verknüpft, wobei es darauf ankommt, jeweils Werte zu finden, welche die drei genannten Bedingungen erfüllen. Die theoretische Bedingungserfüllung muß dann natürlich noch den konkreten Verhältnissen für konkrete Elektronenmikroskope angepaßt werden, die ja je nach Anforderungen und Einsatzzweck unterschiedlich sind und baufehlerbedingte Abweichungen von der theoretischen Berechnung aufweisen.

Ein Strahlengang, wie beansprucht und mittels eines Ausführungsbeispiels in Fig. 1 gezeichnet, ist die Theorie und somit ein Ideal, das in der Praxis deshalb nicht erreicht werden kann, weil jede Teilefertigung immer Fehler, wenn auch sehr geringfügige, aufweist. Korrektoren sind jedoch äußerst empfindliche Systeme, die auch schon durch geringste Fehler von ihrer vorbestimmten Funktion abweichen. Würde man deshalb nur Teile verwenden, bei denen ein Maximum an mechanischer Fehlerfreiheit erzielt werden konnte, hätte man viele Ausschlußteile, was sehr unwirtschaftlich wäre.

Es besteht aber die Möglichkeit, solchen Fehlern entgegenzusteuern, indem man bestimmte Parameter geringfügig verändert, wie zum Beispiel eine Veränderung der Erregung einer Linse mit der Folge einer geringen Veränderung des Strahlengangs, der dann aber durch eine veränderte Erregung einer anderen Linse wieder korrigiert wird, damit der erfindungsgemäße Fokus erhalten bleibt. Typischerweise reicht dazu eine Erregungsveränderung in einem Bereich bis zu 5% aus. Es wird also ein gewisser Justierfreiheitsgrad genutzt.

Beispiele für solche korrigierenden Veränderungen sind Veränderungen der Erregung einer oder beider äußeren Rundlinsen (im gezeichneten Ausführungsbeispiel sind dies 7" und 8") mit einer Fokuskorrektur durch eine Erregungsveränderung der an den jeweiligen äußeren Hexapol angrenzenden Linse, nämlich der Kondensorlinse (16) oder der ersten Transferlinse (11'). Auch andere derartige Möglichkeiten sind denkbar.

Bei der Vornahme einer solchen Korrektur geben die unerwünschten parasitären Fehler an, in welche Richtung die Korrektur vorzunehmen ist. Das Ausmaß der Korrektur erfolgt dann ergebnisorientiert.

Solche sehr begrenzte Abweichungen lösten entsprechend begrenzte Abweichungen anderer Parameter aus. Wie dies im Grunde genommen bei jeder, durch mechanische oder elektrische Parameter definierten Erfindung der Fall ist, müssen somit auch hier innerhalb der funktionalen Ergebniserzielung Toleranzbereiche in den Schutzbereich einbezogen werden. Die Einbeziehung von Grenzbereichen in den Schutzbereich ergibt sich ohnehin schon daraus, daß Strahlenbegrenzungen in einem realen Strahlengang immer Bereiche und keine exakten Linien darstellen.

Dies ist keine Abweichung vom erfindungsgemäßen Prinzip, sondern eine Korrektur in der realen Ausführung, um der Erzielung des erfindungsgemäßen Prinzips zu dienen.

Die Unteransprüche 2 bis 7 geben zweckmäßige Bereiche und konkrete optimale Verhältnisse an:

Das Verhältnis $d = \Delta z / L'$, also des weiteren Abstandes $\Delta z$ zu den Längen $L'$ der äußeren identischen Multipolelemente 1 und 3, liegt zweckmäßigerweise in einem Bereich von 0,5 bis 0,95.

Das Verhältnis der Stärke des Hexapolfeldes $\Psi_{HP2}$ des zentralen Multipolelements 2 zur Stärke $\Psi_{HP1,3}$, also,

$$\frac{\Psi_{HP2}}{\Psi_{HP1,3}}$$

, liegt vorzugsweise in einem Bereich von 0,33 bis 1,7.

Das Verhältnis $M$ der Brennweiten $f$ der näher an der Symmetrieebene 6 liegenden Rundlinsen 7' und 8' zu den Brennweiten $f'$ der weiter entfernt liegenden Rundlinsen 7" und 8", also $M = f / f'$, liegt zweckmäßigerweise in einem Bereich von 0,8 bis 1,2, vorzugsweise jedoch bei $M = 1,15$ mit einer Toleranz von $\pm 0,01$.

Das Verhältnis $k$ der Länge $L$ des zentralen Multipolelements 2 zu der Länge $L'$ der äußeren Multipole 1 und 3, also $k = L / L'$ in einem Bereich von 2,0 bis 3,5, vorzugsweise ist $k=3,05(\pm0,05)$.

Eine Weiterbildung des erfindungsgemäßen Korrektors dient der Kompensation von Baufehlern, wobei Fehler erzeugt werden, die die Fehler, welche durch Baufehler verursacht werden, kompensieren. Dazu ist vorgesehen, daß die Symmetrieebenen von zusätzlich zwischen den Rundlinsen der Rundlinsenduplets angeordneten Hexapolduplets von den näher an der Symmetrieebene liegenden Rundlinsen in der Entfernung derer Brennweiten und von den zur Symmetrieebene weiter weg liegenden Rundlinsen in der Entfernung derer Brennweiten angeordnet sind, wobei die Hexapolduplets derart aufgebaut und erregt sind, daß innerhalb des Korrektors kleine Variationen des Dreilappfehlers vierter Ordnung zur Kompensation von durch Baufehler verursachten Fehlern mit umgekehrten Vorzeichen erzeugt werden können.

Weitere Baufehler können dadurch kompensiert werden, daß die Symmetrieebenen von zusätzlich zwischen den Rundlinsen der Rundlinsenduplets angeordneten Hexapolduplets von den näher an der Symmetrieebene liegenden Rundlinsen in der Entfernung derer Brennweiten und von den zur Symmetrieebene weiter weg liegenden Rundlinsen in der Entfernung derer Brennweiten angeordnet sind, wobei die Hexapolduplets derart aufgebaut und erregt sind, daß kleine Variationen der residualen Fehler, insbesondere $D_6$, $A_5$, möglich werden, die wiederum die Kompensation von parasitären Fehlern ermöglichen oder die Minimierung des Einflusses von Fehlern höherer Ordnung der gleichen Zähligkeit, insbesondere $D_8$ und $G_7$, ermöglichen.

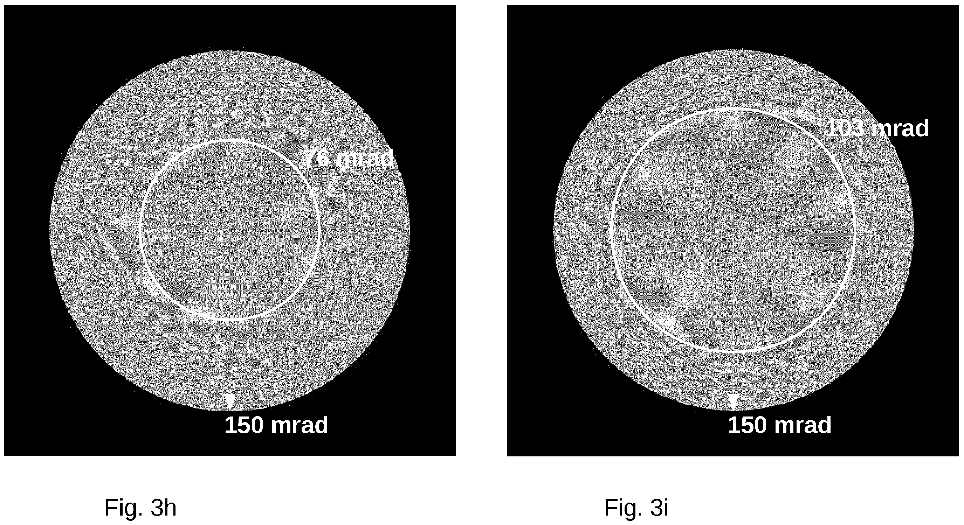

Bei dieser Kompensation handelt es sich nicht um eine Korrektur, sondern um eine die erfindungsgemäße Korrektur ergänzende Optimierung, ähnlich wie eingangs zur EP 3 255 649 A1 von Morishita beschrieben. Es wird also nicht der Fehler korrigiert, sondern seine Auswirkung auf die Bildqualität minimiert. Diese Weiterbildung entspricht einer Bildverbesserung, die der unten beschriebenen Figur 3i gegenüber der Figur 3h entspricht.

Die Erfindung betrifft weiterhin ein Elektronenmikroskop, das mit dem oben beschriebenen Korrektor ausgestattet ist. Dabei handelt es sich vorzugsweise um ein Rasterelektronenmikroskop (REM) oder ein Raster-Transmissionselektronenmikroskop (STEM).

Es kann sich auch um ein Transmissionselektronenmikroskop (TEM) handeln, bei dem der Korrektor bezüglich des Strahlengangs der Objektivlinse nachgeschaltet ist.

Bei derartigen Transmissionselektronenmikroskopen ist der Strahlengang im Vergleich zu den vorgenannten Elektronenmikroskopen und dem beispielhaft in Fig. 1 gezeichneten umgekehrt. Solche Umkehrungen sind bekannt, wir verweisen diesbezüglich auf die Veröffentlichung R. Ernie, "Aberration-Corrected Imaging in Transmission Elektron Microscopy", 2010, Seite 48, Fußnote 1. Dort finden sich auch die Hinweise auf Pogany und Turner, 1968, sowie Cowley, 1969, welche das Reziprozitätstheorem lehrten.

Bei einem der vorgenannten Mikroskope ist zweckmäßigerweise zwischen dem Korrektor und der Objektivlinse ein Transferlinsensystem eingefügt, mit dem Öffnungsfehler korrigierbar sind. Ein solches Transferlinsensystem kann sowohl aus einer, als auch aus zwei Transferlinsen bestehen.

Das Transferlinsensystem mit zwei Transferlinsen ist zweckmäßigerweise derart ausgebildet, daß die Transferlinsen derart verschiedene Brennweiten aufweisen, daß sich damit die Objektivlinsenöffnungsfehler eliminieren lassen. Dabei kann vorgesehen sein, daß mittels der Erregung der Spulen der Transferlinsen die Brennweiten der Transferlinsen zur Eliminierung der konkreten Objektivlinsenöffnungsfehler einstellbar sind.

Die Erfindung wird nachfolgend anhand der Zeichnung erläutert. Es zeigen

**Fig. 1**          Ein Ausführungsbeispiel eines erfindungsgemäßen Korrektors sowie ein Transferlinsensystem und

**Fig. 2a, 2b und 2c**   ein Vergleich der Fehlerkompensation des Standes der Technik und der Erfindung anhand von Vektoren.

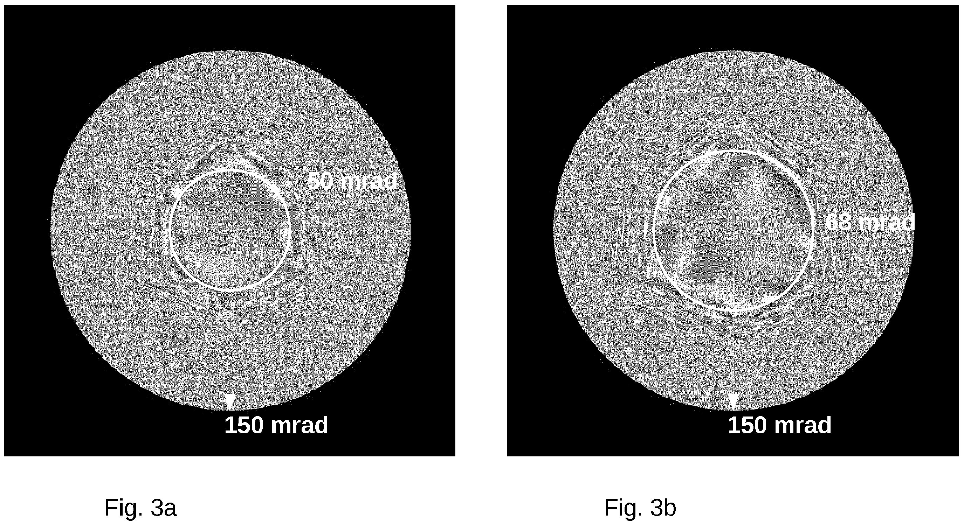

Außerdem ist anhand eines Ronchigramms, **Fig. 3a bis 3i,** der Korrektureffekt der Fehlerkorrektur des erfindungsgemäßen Korrektors im Vergleich zu den Fehlerkorrekturen der Korrektoren des Standes der Technik dargestellt.

In **Fig. 1** ist ein Ausführungsbeispiel eines erfindungsgemäßen teilchenoptischen Korrektors 5 sowie ein Ausführungsbeispiel eines weiterbildungsgemäß hinzugefügtes Transferlinsensystem 11 dargestellt. Der Einbau in ein Elektronenmikroskop ist durch die optische Achse 4, die Kondensorlinse 16 und eine Objektivlinse 13 mit zwei Objektivlinsenfeldern 13', 13" mit den Brennweiten f'''' sowie durch den Detektor 15, der bei einem Rasterelektronenmikroskop der Bilderzeugung dient, fragmentarisch veranschaulicht, Zwischenlinsen sind weggelassen. Die Probe 14 befindet sich zwischen den Objektivlinsenfeldern 13 und 13'. Die Objektivlinse 13 kann auch nur ein Objektivlinsenfeld aufweisen, hinter dem sich die Probe befindet. $u_\alpha$ zeigt den axialen Strahlengang und $u_\gamma$ den außeraxialen Strahlengang.

Der Korrektor 5 besteht aus drei Multipolelementen 1, 2 und 3, einem zentralen Multipolelement 2, das in der Symmetrieebene 6 des Korrektors 5 liegt, und aus zwei äußeren Multipolelementen 1 und 3, die identisch sind. Das zentrale Multipolelement 2 weist ein Hexapolfeld der Stärke $\Psi_{HP2}$ und eine Länge $L$ auf. Die zwei äußeren Multipolelemente 1 und 3 weisen Hexapolfelder der Stärke $\Psi_{HP1,3}$ und eine Länge $L'$ auf. Zwischen den Multipolelementen 1, 2 und 3 sind Rundlinsendupletts 7 und 8 mit den Rundlinsen 7', 7" und 8', 8" angeordnet. Die Rundlinsen 7' und 8' sind in der Entfernung ihrer Brennweiten $f$ von der Symmetrieebene 6 angeordnet und die Rundlinsen 7" und 8" mit den Brennweiten $f'$ haben von den Rundlinsen 7' und 8' die Entfernung beider Brennweiten $f$ und $f'$. Die äußeren identischen Multipolelemente 1 und 3 sind von den Rundlinsen 7" und 8" jeweils deren Brennweite $f'$ und zuzüglich eines Maßes $\Delta z$ entfernt, wobei sich diese Entfernungen jeweils auf die Symmetrieebenen 1', 6 und 3' der Hexapolelemente 1, 2 und 3 beziehen, beziehungsweise auch bei den Rundlinsen auf deren Symmetrieebenen.

Wie oben schon beschrieben ist das Verhältnis der Stärke des Hexapolfeldes $\Psi_{HP2}$ des zentralen Multipolelements 2 zu den Stärken der Hexapolfelder $\Psi_{HP1,3}$ der äußeren Multipolelemente 1, 3 derart bemessen, daß der dreizählige Astigmatismus $A_2$ verschwunden ist.

Gemäß der obigen näheren Beschreibung ist das Maß $\Delta z$ erfindungsgemäß derart gewählt, daß für vorgegebene Längen $L$ und $L'$ der Multipolelemente 1, 2, und 3 der axiale Dreilappfehler vierter Ordnung $D_4$ verschwindet. Wobei die Länge des zentralen Multipols 2 ein solches Verhältnis $k$ zu den Längen $L'$ der äußeren Multipolelemente 2 und 3 hat, daß für ein vorgegebenes Verhältnis $M = f / f'$ der Brennweiten f der Rundlinsen 7' und 8' zu den Brennweiten $f'$ der Rundlinsen 7" und 8" der axiale Dreilappfehler $D_6$ erfindungsgemäß verschwunden ist.

In dem Korrektor 5 tritt ein von der Strahlenquelle kommender und durch Kondensorlinse(n) gebündelter Strahl rund ein, der durch den axialen Strahlengang $u_\alpha$ und den außeraxialen Strahlengang $u_\gamma$ dargestellt ist. Der Strahl wird zunächst durch das erste äußere Multipolelement 1 deformiert und in der ersten Hälfte des zentralen Multipolelements 2 wieder rund gemacht, danach in der zweiten Hälfte des Multipolelements 2 erneut dreizählig deformiert und mit dem dritten äußeren Multipolelement 3 wieder rund gemacht. Die unrunden Strahlbereiche dienen nach der Grundlage von O. Scherzer (siehe oben) der beschriebenen Fehlerkorrektur. Dies ist die Grundlage des erfindungsgemäßen teilchenoptischen Korrektors 5.

Weiterhin dargestellt sind zusätzliche Hexapoldupletts 9, 9' und 10, 10', welche zwischen den Rundlinsen 7' und 7" sowie 8' und 8" der Rundlinsendupletts 7 und 8 angeordnet sind, wobei deren Symmetrieebenen 9", 10" von den Rundlinsen 7', 7", 8', 8" jeweils eine Entfernung aufweisen, die deren Brennweiten f, f' entspricht.

Der Aufbau und die Erregung dieser Hexapoldupletts 9, 9' und 10, 10' ist derart gewählt, daß zur Kompensation von durch Baufehler des Elektronenmikroskops oder des Korrektors 5 verursachten parasitären Bildfehlern erzeugte kleine Variationen des Dreilappfehlers vierter Ordnung $D_4$ mittels der erzeugten, diesen Fehlern entgegengerichteten Fehlern, ausgelöscht werden können.

Die Zeichnung zeigt auch ein Transferlinsensystem 11, das dem Korrektor nachgeschaltet ist und über zwei Transferlinsen 11' und 11" verfügt. Diese weisen derart verschiedene Brennweiten $f''$ und $f'''$ auf, daß sich dadurch die Öffnungsfehler der Objektivlinse 13, eliminieren lassen. Für eine genaue Einstellung dieser Elimination können die Brennweiten $f''$, $f'''$ durch die Erregung der Spulen der Transferlinsen 11' und 11" in einem gewissen Bereich variiert werden. Die Elimination von Öffnungsfehlern muß vor dem Auftreffen des Strahls auf die Probe 14 erfolgen.

In dem Transferlinsensystem 11 können für ein Rasterelektronenmikroskop Elektromagnete 12, 12' für die Ablenkung des Rasterstrahls angeordnet sein.

Die **Fig. 2a, 2b und 2c** zeigen Darstellungen von Fehlerkompensationen des Standes der Technik und der Erfindung anhand von Vektoren a, b und c.

Dabei entsteht der Vektor a durch die Fehler $A_2$ und $D_4$ im Hexapolfeld und der Vektor b durch den Fehler $A_5$ im Hexapolfeld. Der Vektor c ist die Resultante der Vektoren a und b und gibt den Fehler $D_6$ an. Es handelt sich dabei um zweidimensionale Vektoren in einer Ebene senkrecht zur Symmetrieachse.

Die **Fig. 2a** zeigt, wie sich bei Rose (siehe oben) die Resultante c aus den Vektoren a und b ergibt. Daß hier diese Resultante entsteht, kommt daher, daß sich der Kombinationsfehler aus $A_2$ und $D_4$, der den Vektor a ausmacht, und der kleine Kombinationsfehler aus $A_5$ des Vektors b sich nicht kompensieren können. Der Vektor c ist etwa so groß wie der Vektor a, der etwa bereits den gesamten Fehler $D_6$ verursacht.

Die **Fig. 2b** zeigt dasselbe beim Deltakorrektor (siehe oben), bei dem es zu einem resultierenden Fehler $D_6$ kommt, weil die Vektoren a und b partiell in die gleiche Richtung zeigen.

Schließlich zeigt die **Fig. 2c,** wie die Kombinationsfehlervektoren a und b der Fehler $A_2$ und $D_4$ sowie $A_5$ parallel aber gegeneinander gerichtet sind, also verschiedene Vorzeichen aufweisen. Dadurch heben sich die Kombinationsfehler von $A_2$ und $D_4$ mit dem Hexapolfeld einerseits und der Kombinationsfehler $A_5$ mit dem Hexapolfeld andererseits gegenseitig auf, so daß kein Fehler $D_6$ übrigbleibt.

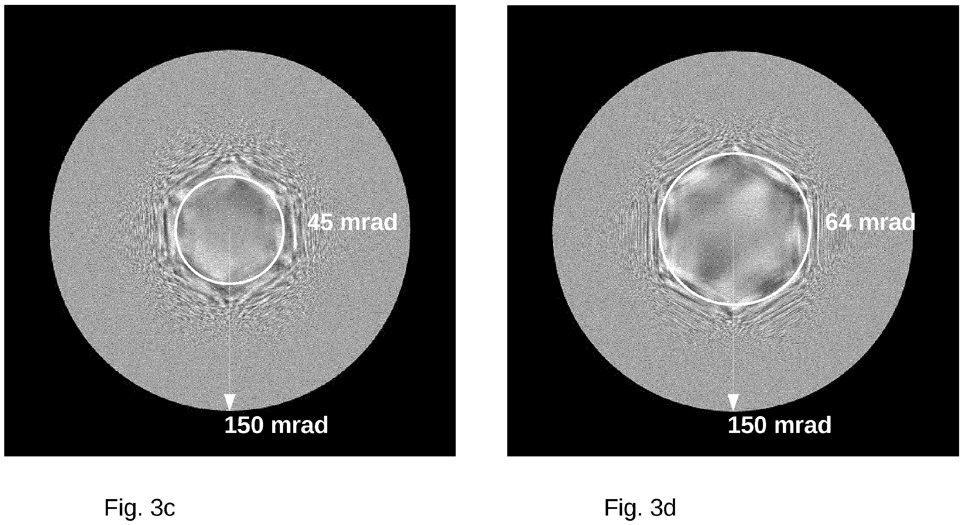

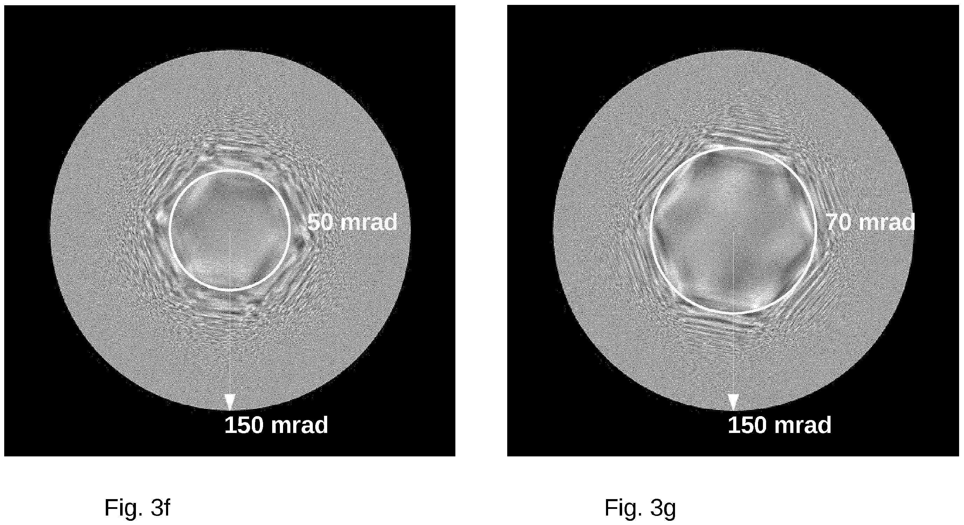

Die **Figuren 3a bis 3** i zeigen jeweils Ronchigramme, das sind Hellfeldbilder von runden Strahlenbündeln, die der Abbildung dienen, beispielsweise der Strahlen eines Rasterelektronenmikroskops, die das Objekt abrastern würden. Dabei ist ein mittlerer Bereich zu sehen, der aufgrund sehr hoher Vergrößerung (Abbildung mit fast punktförmig fokussierter Sonde) keine Strukturen aufweist. Das bedeutet, die Fokussierung dieses zentralen Aperturbereiches ist nahezu ideal. Dieser Bereich ist umgeben von im Wesentlichen sechseckigen Strukturen. Die äußeren Aperturbereiche werden nämlich in 3- oder 6-zähligen Schweifen der fokussierten Sonde abgebildet, so daß größere Bereiche des (als amorph angenommenen) Objekts getroffen werden, also die Vergrößerung sinkt, wodurch Strukturen sichtbar werden. Dabei zeigen die Fig. 3a, 3c, 3e, 3f und 3h die Strahlenbündel ohne Kompensation und die Fig. 3b, 3d, 3g und 3i mit Kompensation (analog zu Morishita in EP 3 255 649 A1 - siehe oben). Dabei wurde eine typische zu korrigierende Objektivlinse (f = 1,4 mm, Cs = 1,1 mm) bei geringer Beschleunigungsspannung (30kV) und eine monochromatisierte Elektronenquelle ($\Delta E$ = 0,1 eV) angenommen. Die "fehlerfreie Apertur" wird zur Illustration mit einer maximalen Phasenschiebung von $\pi$ eingezeichnet. In der Tabelle 1 sind die zu den Abbildungen gehörigen Fehlerkoeffizienten aufgeführt.

| [mm] | 3a | 3b | 3c | 3d | 3e | 3f | 3g | 3h | 3i |
|---|---|---|---|---|---|---|---|---|---|
| $D_4$ | 0 | 0.02/180° | 0 | 0.03/180° | 0 | 0 | 0.02/117° | 0 | 0 |
| $A_5$ | 0.2/90° | 0.2/90° | 0 | 0 | 0 | 0 | 0 | 0 | 0.1/-47° |
| $D_6$ | 4.3/0° | 4.3/0° | 8.9/0° | 8.9/0° | 0 | 4.3/-63° | 4.3/-63° | 0 | 0.2/22° |
| $G_7$ | - | - | - | - | 252/0° | - | - | 1.6/-133° | 1.6/-133° |
| $D_8$ | - | - | - | - | - | - | 35/-23° | 21/-158° | 21/-158° |

Es zeigen

Fig. 3a ein Ronchigramm des Korrektors nach Müller et al. (2006 - siehe oben). Es handelt sich um einen Zwei-Hexapol-Korrektor ohne Optimierung. Die fehlerfreie Apertur des Strahlenbündels beträgt 50 mrad.

Fig. 3b zeigt ein Ronchigramm desselben Korrektors in optimiertem Zustand, wobei die fehlerfreie Apertur des Strahlenbündels 68 mrad aufweist.

**Fig. 3c** zeigt ein Ronchigramm des aus der EP 2 325 862 A1 bzw. EP 2 325 863 B1 (jeweils von S. Henstra - siehe oben) bekannten Zwei-Hexapol-Korrektors mit doppelter Normalerregung der Hexapole und dem zusätzlichen Multipol mit dem Bezugszeichen 126. Die fehlerfreie Apertur des Strahlenbündels beträgt 45 mrad.

**Fig. 3d** zeigt ein Ronchigramm dieses Korrektors mit Optimierung der Phasenschiebung, wobei eine fehlerfreie Apertur von 64 mrad erzielt wird.

**Fig. 3e** zeigt den Henstra-Korrektor gem. Fig. 3c bzw. 3d mit dem zusätzlichen Zwölfpol mit dem Bezugszeichen 128. Aufgrund des vom Zwölfpol eingeführten Kranzfehlers ($G_7$) beträgt die fehlerfreie Apertur nur 44 mrad.

Die **Fig. 3f und 3g** zeigen den oben genannten Deltakorrektor mit und ohne Kompensation, wobei fehlerfreie Aperturen von 50 mrad und 70 mrad erzielt werden.

Die **Fig. 3h und 3i** zeigen schließlich den erfindungsgemäßen Korrektor, der ohne optimierte Phasenschiebung eine fehlerfreie Apertur von 76 mrad und mit Optimierung eine fehlerfreie Apertur von 103 mrad erreicht. Diese Kompensation wird durch die Maßnahmen gem. Anspruch 9 erzielt.

**Bezugszeichenliste**

| | |
|---|---|
| 1 | erstes äußeres Multipolelement |
| 1' | Symmetrieebene des ersten äußeren Multipolelements |
| 2 | zentrales Multipolelement |
| 3 | zweites äußeres Multipolelement |
| 3' | Symmetrieebene des zweiten äußeren Multipolelements |
| $\Psi_{HP2}$ | Stärke des Hexapolfeldes des zentralen Multipolelements |
| $\Psi_{HP1,3}$ | Stärken der äußeren identischen Multipolelemente 1 und 3 |
| L | Länge des zentralen Multipolelements 1 |
| L' | Längen der identischen Multipolelemente 2 und 3 |
| 4 | optische Achse |
| 5 | Korrektor |
| 6 | Symmetrieebene des Korrektors |
| 7 | Rundlinsenduplett |
| 7' | Rundlinse (zur Symmetrieebene näher) |
| 7" | Rundlinse (zur Symmetrieebene weiter) |
| 8 | Rundlinsenduplett |
| 8' | Rundlinse (zur Symmetrieebene näher) |
| 8" | Rundlinse (zur Symmetrieebene weiter) |
| f | Brennweiten von 7' und 8' |
| f' | Brennweiten von 7" und 8" |
| $\Delta z$ | weiterer Abstand |
| 9,9' | Hexapolduplett |
| 10, 10' | Hexapolduplett |
| 9", 10" | Symmetrieebenen der Hexapoldupletts 9, 9' und 10, 10' |
| 11 | Transferlinsensystem |
| 11' | erste Transferlinse |
| 11" | zweie Transferlinse |
| f", f''' | verschiedene Brennweiten der Transferlinsen 11', 11" |
| 12, 12' | Elektromagnete zur Ablenkung des Rasterstrahls |
| 13 | Objektivlinse |
| 13', 13" | Objektivlinsenfelder |
| f''' | Brennweite Objektivlinsen |
| 14 | Probe |
| 15 | Detektor |
| 16 | Kondensorlinse |
| $u_\alpha$ | axialer Strahlengang |
| $u_\gamma$ | außeraxialer Strahlengang |
| $\alpha$ | Aperturwinkel |
| a | Vektor der Fehler $A_2$ und $D_4$ im Hexapolfeld |
| b | Vektor des Fehlers $A_5$ im Hexapolfeld |
| c | Vektor des Fehlers $D_6$, der die Resultante von a und b ist. |

**Formeln**

Beugung: $\lambda \, / \, \alpha$

relative Verschiebung: $d = \Delta z \, / \, L'$

Zwischenvergrößerung: $M = f \, / \, f'$

Längenverhältnis: $k = L \, / \, L'$

Verhältnis der Hexapolstärken:

$$\frac{\Psi_{HP2}}{\Psi_{HP1,3}} = \frac{2}{k \cdot M^3}$$

Permeabilität des Vakuums: $\mu_0 = 4\pi \cdot 10^{-7}$ As/Vm

Stärke des Hexapols: $\Psi = \mu_0 \cdot N \cdot I \cdot R^{-3}$

$D_4$ Regel:

$$d = \frac{\Delta z}{L'} = \frac{10k - \sqrt{5} \cdot \sqrt{9M^4 - k^2}}{30M^2}$$

$D_{6x}$ Integrale:

$$\Delta D_{6x}^{(a)} = 3 \int \Psi(z) \cdot X_{\langle A2 \rangle}(z) \cdot X_{\langle D4 \rangle}(z) \cdot u_\alpha(z) \; dz$$

und

$$\Delta D_{6x}^{(b)} = 3 \int_{HP2} \Psi(z) \cdot X_{\langle A5 \rangle}(z) \cdot u_\alpha^2(z) \; dz$$

**Patentansprüche**

1. Teilchenoptischer Korrektor (5) zum Korrigieren der Öffnungsfehler ($C_3$, $C_5$) eines Elektronenmikroskops unter Vermeidung des dreizähligen axialen Astigmatismus ($A_2$), des axialen Dreilappfehlers vierter Ordnung ($D_4$) und des sechszähligen axialen Astigmatismus ($A_5$), wobei der Korrektor (5) ein zentrales Multipolelement (2) der Länge L zur Erzeugung eines Hexapolfeldes ($\Psi_{HP2}$) in der Symmetrieebene (6) des Korrektors (5) sowie zwei äußere identische Multipolelemente (1, 3 ) der Länge L' zur Erzeugung gleich starker Hexapolfelder ($\Psi_{HP1}$, $\Psi_{HP3}$) und zwei Rundlinsendupletts (7 und 8) mit Rundlinsen (7', 7", 8', 8") aufweist, wobei die zur Symmetrieebene (6) näheren Rundlinsen (7' und 8') zur Symmetrieebene (6) im Abstand der Brennweiten (f) der Rundlinsen (7', 8') angeordnet sind, und die zur Symmetrieebene (6) weiter entfernten Rundlinsen (7", 8") von letzteren einen Abstand aufweisen, der ihren Brennweiten (f') zuzüglich der Brennweiten (f) der Rundlinsen (7', 8'), die näher zur Symmetrieebene (6) liegen, entspricht,
**dadurch gekennzeichnet,**
**daß** die Stärke des zentralen Hexapolfeldes ($\Psi_{HP2}$) zu den Stärken der beiden gleich starken äußeren Hexapolfelder ($\Psi_{HP1,3}$) derart gewählt ist, daß der dreizählige axiale Astigmatismus ($A_2$) verschwindet und die Stärken ($\Psi_{HP1,3}$) letzterer so gewählt sind, daß der Korrektor (5) insgesamt keinen sechszähligen axialen Astigmatismus ($A_5$) hat, daß der Abstand der Multipolelemente (1 und 3) von den der Symmetrieebene (6) weiter entfernten Rundlinsen (7", 8"), deren Brennweite (f') zuzüglich eines weiteren Abstands ($\Delta z$) entspricht, wobei letzterer so gewählt ist, daß für die gegebenen Längen L und L' der axiale Dreilappfehler vierter Ordnung ($D_4$) verschwindet, und daß die Länge (L) des zentralen Multipolelements (2) im Verhältnis zu den Längen (L') der zwei äußeren identischen Multipolelemente (1 und 3) derart gewählt ist, daß der axiale Dreilappfehler sechster Ordnung ($D_6$) - für das vorgegebene Verhältnis ($M = f / f'$) der Brennweite (f') der zur Symmetrieebene (6) näheren Rundlinsen (7', 8') zu der Brennweite (f) der zur Symmetrieeiebne (6) weiter entfernten Rundlinsen (7", 8") - verschwindet.

**2.** Korrektor nach Anspruch 1,
**dadurch gekennzeichnet,**
**daß** das Verhältnis (d) des weiteren Abstandes ($\Delta z$) zu den Längen ($L'$) der äußeren Multipolelemente (1 und 3)
0,5 bis 0,95 ist ( $d = \frac{\Delta z}{L'} = 0{,}5$ bis 0,95).

**3.** Korrektor nach Anspruch 1 oder 2,
**dadurch gekennzeichnet,**
**daß** die Stärke des Hexapolfeldes ($\Psi_{HP2}$) des zentralen Multipolelements (2) zur Stärke ($\Psi_{HP1,3}$) der äußeren
Hexapolfelder (1, 3) 0,33 bis 1,7 ist

$$\left( \frac{\Psi_{HP2}}{\Psi_{HP1,3}} = 0{,}33 \text{ bis } 1{,}7 \right)$$

**4.** Korrektor nach einem der Ansprüche 1 bis 3,
**dadurch gekennzeichnet,**
**daß** das Verhältnis (M) der Brennweiten ($f$) der näher an der Symmetrieebene (6) liegenden Rundlinsen (7', 8') zu
den Brennweiten ($f$) der weiter entfernt liegenden Rundlinsen (7", 8"), also $M = f / f$, in einem Bereich von 0,8 bis
1,2 liegt.

**5.** Korrektor nach Anspruch 4,
**dadurch gekennzeichnet,**
**daß** $M$= 1,15 ($\pm$ 0,01) ist.

**6.** Korrektor nach einem der Ansprüche 1 bis 5,
**dadurch gekennzeichnet,**
**daß** das Verhältnis ($k$) der Länge ($L$) des zentralen Multipolelements (2) zu der Länge ($L'$) der äußeren Multipole (1
und 3), also $k = L / L'$, im Bereich von 2,0 bis 3,5 liegt.

**7.** Korrektor nach Anspruch 6,
**dadurch gekennzeichnet,**
**daß** $k$= 3,05 ($\pm$ 0,05) ist.

**8.** Korrektor nach einem der Ansprüche 1 bis 7,
**dadurch gekennzeichnet,**
**daß** die Symmetrieebenen (9" und 10") von zusätzlich zwischen den Rundlinsen (7', 7"; 8', 8") der Rundlinsendupletts
(7, 8) angeordneten Hexapoldupletts (9, 9'; 10, 10') von den Rundlinsen (7', 8') in der Entfernung ihrer Brennweiten
($f$) und von den Rundlinsen (7" und 8") in der Entfernung ihrer Brennweiten ($f$) angeordnet sind, wobei die Hexapoldupletts (9, 9'; 10, 10') derart aufgebaut und erregt sind, daß innerhalb des Korrektors (5) kleine Variationen des
Dreilappfehlers vierter Ordnung ($D_4$) zur Kompensation von durch Baufehler verursachten Fehlern erzeugt werden
können.

**9.** Korrektor nach einem der Ansprüche 1 bis 8,
**dadurch gekennzeichnet,**
**daß** die Symmetrieebenen (9" und 10") von zusätzlich zwischen den Rundlinsen (7', 7"; 8', 8") der Rundlinsendupletts
(7, 8) angeordneten Hexapoldupletts (9, 9'; 10, 10') von den Rundlinsen (7', 8') in der Entfernung ihrer Brennweiten
($f$) und von den Rundlinsen (7" und 8") in der Entfernung ihrer Brennweiten ($f$) angeordnet sind, wobei die Hexapoldupletts (9, 9'; 10, 10') derart aufgebaut und erregt sind, daß kleine Variationen der residualen Fehler, insbesondere $D_6$, $A_5$, möglich werden, die wiederum die Kompensation von parasitären Fehlern ermöglichen oder die Minimierung des Einflusses von Fehlern höherer Ordnung der gleichen Zähligkeit, insbesondere $D_8$ und $G_7$ ermöglichen.

**10.** Elektronenmikroskop,
**dadurch gekennzeichnet,**
**daß** es mit einem Korrektor (5) nach einem der Ansprüche 1 bis 9 ausgestattet ist.

**11.** Elektronenmikroskop nach Anspruch 10,
**dadurch gekennzeichnet,**
**daß** es ein Rasterelektronenmikroskop (REM) ist.

**12.** Elektronenmikroskop nach Anspruch 10 und 11,
**dadurch gekennzeichnet,**
**daß** es ein Raster-Transmissionselektronenmikroskop (STEM) ist.

**13.** Elektronenmikroskop nach Anspruch 10,
**dadurch gekennzeichnet,**
**daß** es ein Transmissionselektronenmikroskop (TEM) ist, bei dem der Korrektor (5) bezüglich des Strahlengangs der Objektivlinse (13) nachgeschaltet ist.

**14.** Elektronenmikroskop nach einem der Ansprüche 10 bis 13,
**dadurch gekennzeichnet,**
**daß** zwischen dem Korrektor (5) und der Objektivlinse (13) ein Transferlinsensystem (11) eingefügt ist, mit dem Öffnungsfehler korrigierbar sind.

**15.** Elektronenmikroskop nach Anspruch 14,
**dadurch gekennzeichnet,**
**daß** das Transferlinsensystem (11) aus einer Transferlinse besteht.

**16.** Elektronenmikroskop nach Anspruch 14,
**dadurch gekennzeichnet,**
**daß** das Transferlinsensystem (11) aus zwei Transferlinsen (11', 11") besteht.

**17.** Elektronenmikroskop nach Anspruch 16,
**dadurch gekennzeichnet,**
**daß** die Transferlinsen (11', 11") derart verschiedene Brennweiten (*f"*, *f‴*) aufweisen, daß sich damit die Objektivlinsenöffnungsfehler eliminieren lassen.

**18.** Elektronenmikroskop nach Anspruch 17,
**dadurch gekennzeichnet,**
**daß** mittels der Erregung der Spulen der Transferlinsen (11', 11") die Brennweiten (*f"*,*f‴*) der Transferlinsen (11', 11") zur Eliminierung der konkreten Objektivlinsenöffnungsfehler einstellbar sind.

**Claims**

**1.** Particle-optical corrector (5) for correcting the spherical aberrations ($C_3$, $C_5$) of an electron microscope, thereby preventing the threefold axial astigmatism ($A_2$), the axial three-lobed aberration of fourth order ($D_4$) and the sixfold axial astigmatism ($A_5$), wherein the corrector (5) comprises a central multipole element (2) of length $L$ for generating a hexapole field ($\Psi_{HP2}$) in the symmetry plane (6) of the corrector as well as two outer identical multipole elements (1, 3) of length $L'$ for generating identically strong hexapole fields ($\Psi_{HP1}$, $\Psi_{HP3}$) and two round lens doublets (7 and 8) with round lenses (7', 7", 8', 8"), wherein the round lenses (7' and 8') which are closer to the symmetry plane (6) are arranged at a separation of the focal lengths ($f$) of the round lenses (7', 8') with respect to the symmetry plane (6), and the round lenses (7", 8") which are further away from the symmetry plane (6) are disposed at a separation from the round lenses (7', 8') which corresponds to their focal lengths ($f'$) plus the focal lengths ($f$) of the round lenses (7', 8') which are disposed closer to the symmetry plane (6),
**characterized in that** the strength of the central hexapole field ($\Psi_{HP2}$) with respect to the strengths of the two identically strong outer hexapole fields ($\Psi_{HP1,3}$) is chosen such that the threefold axial astigmatism ($A_2$) vanishes and the strengths ($\Psi_{HP1,3}$) of the latter are chosen such that the overall corrector (5) does not have a sixfold axial astigmatism ($A_5$), that the separation between the multipole elements (1 and 3) and round lenses (7", 8") located further away from the symmetry plane (6), corresponds to the focal length ($f'$) thereof plus an additional separation ($\Delta z$), wherein the latter is chosen such that for the stated lengths $L$ and $L'$, the axial three-lobed aberration of fourth order ($D_4$) vanishes and that the length ($L$) of the central multipole element (2) is selected relative to the lengths ($L'$) of the two outer identical multipole elements (1 and 3) in such a manner that the axial three-lobed aberration of sixth order ($D_6$) vanishes for the stated ratio ($M = f / f'$) between the focal length ($f$) of the round lenses (7', 8') that are closer to the symmetry plane (6) and the focal length ($f$) of the round lenses (7", 8") that are further away from the symmetry plane.

2. Corrector according to claim 1, **characterized in that** the ratio (d) between the additional separation ($\Delta z$) and the lengths ($L'$) of the outer multipole element (1 and 3) is between 0.5 and 0.95 ( $d = \frac{\Delta z}{L'} = 0.5$ to 0.95).

3. Corrector according to claim 1 or 2, **characterized in that** the strength of the hexapole field ($\Psi_{HP2}$) of the central multipole element (2) with respect to the strength ($\Psi_{HP1,3}$) of the outer hexapole fields (1, 3) is between 0.33 and 1.7

$$\left( \frac{\Psi_{HP2}}{\Psi_{HP1,3}} = 0.33 \text{ bis } 1.7 \right)$$

4. Corrector according to one of the claims 1 to 3, **characterized in that** the ratio ($M$) between the focal lengths ($f$) of the round lenses (7', 8') located closer to the symmetry plane (6) and the focal lengths ($f$) of the round lenses (7", 8") located further away, i.e. $M = f / f$, is in a range between 0.8 and 1.2.

5. Corrector according to claim 4, **characterized in that** $M = 1.15$ ($\pm 0.01$).

6. Corrector according to any one of the claims 1 to 5, **characterized in that** the ratio ($k$) between the length ($L$) of the central multipole element (2) and the length ($L'$) of the outer multipoles (1 and 3), i.e. $k = L / L'$, is within a range of between 2.0 and 3.5.

7. Corrector according to claim 6, **characterized in that** $k = 3.05$ ($\pm 0.05$).

8. Corrector according to any one of the claims 1 to 7, **characterized in that** the symmetry planes (9" and 10") of hexapole doublets (9, 9'; 10, 10') which are additionally arranged between the round lenses (7', 7"; 8', 8") of the round lens doublets (7, 8) are arranged at a separation from the round lenses (7', 8') equal to their focal lengths ($f$) and are arranged at a separation from the round lenses (7" and 8") equal to their focal lengths ($f$), wherein the hexapole doublets (9, 9'; 10, 10') are structured and excited in such a manner that within the corrector (5) small variations of the three-lobed aberration of fourth order ($D_4$) can be generated for compensating aberrations caused by construction errors.

9. Corrector according to any one of the claims 1 to 8, **characterized in that** the symmetry planes (9" and 10") of hexapole doublets (9, 9'; 10, 10') additionally arranged between the round lenses (7', 7"; 8', 8") of the round lens doublets (7, 8) are arranged at a separation from the round lenses (7', 8') equal to their focal lengths ($f$) and are arranged at a separation from the round lenses (7" and 8") equal to their focal lengths ($f$), wherein the hexapole doublets (9, 9'; 10, 10') are structured and excited in such a manner that small variations of the residual aberrations, in particular $D_6$, $A_5$, become possible, which permit the compensation of parasitic aberrations or the minimization of the influence of higher order aberrations of the same multiplicity, in particular $D_8$ and $G_7$.

10. Electron microscope, **characterized in that** it is provided with a corrector (5) according to one of the claims 1 to 9.

11. Electron microscope according to claim 10, **characterized in that** it is a scanning electron microscope (REM).

12. Electron microscope according to claim 10 and 11, **characterized in that** it is a scanning transmission electron microscope (STEM).

13. Electron microscope according to claim 10, **characterized in that** it is a transmission electron microscope (TEM), in which the corrector (5) is arranged downstream of the objective lens (13) with respect to the beam path.

14. Electron microscope according to any one of the claims 10 to 13, **characterized in that** a transfer lens system (11) is inserted between the corrector (5) and the objective lens (13), by means of which spherical aberrations can be corrected.

**15.** Electron microscope according to claim 14, **characterized in that** the transfer lens system (11) consists of a single transfer lens.

**16.** Electron microscope according to claim 14, **characterized in that** the transfer lens system (11) consists of two transfer lenses (11', 11").

**17.** Electron microscope according to claim 16, **characterized in that** the transfer lenses (11', 11") have different focal lengths ($f''$, $f'''$) such that objective lens spherical aberrations can be eliminated thereby.

**18.** Electron microscope according to claim 17, **characterized in that** by means of excitation of the coils of the transfer lenses (11', 11"), the focal lengths ($f''$, $f'''$) of the transfer lenses (11', 11") can be adjusted for eliminating the specific objective lens spherical aberrations.

**Revendications**

**1.** Correcteur optique des particules (5) pour la correction des erreurs d'ouverture ($C_3$, $C_5$) d'un microscope électronique en évitant l'astigmatisme axial à trois chiffres ($A_2$), de l'erreur trilobée axiale de quatrième ordre ($D_4$) et de l'astigmatisme axial à six chiffres ($A_5$), sachant que le correcteur (5) comporte un élément de multipôles central (2) de longueur $L$ pour générer un champ d'hexapôles ($\Psi_{HPZ}$) dans le plan de symétrie (6) du correcteur (5) ainsi que deux éléments de multipôles identiques extérieurs (1, 3) de longueur $L'$ pour générer des champs d'hexapôles de même puissance (($\Psi_{HP1}$, $\Psi_{HP3}$) et deux doublets de lentilles rondes (7 et 8) avec des lentilles rondes (7', 7", 8', 8"), sachant que les lentilles rondes (7' et 8') plus proches du plan de symétrie (6) sont disposées par rapport au plan de symétrie (6) à distance des distances focales ($f$) des lentilles rondes (7', 8') et les lentilles rondes (7", 8") plus éloignées par rapport au plan de symétrie (6) de ce dernier comporte une distance qui correspond à leurs distances focales ($f'$) en plus des distances focales ($f$) des lentilles rondes (7', 8'), qui se situent plus près du plan de symétrie (6) **caractérisé en ce que** la puissance du champ d'hexapôles central ($\Psi_{HPZ}$) est choisi par rapports aux puissances des deux champs d'hexapôles extérieurs de même puissance ($\Psi_{HP1,3}$) de telle manière que l'astigmatisme axial à trois chiffres ($A_2$) disparaît et les puissances ($\Psi_{HP1,3}$) de ces derniers sont choisis de telle sorte que le correcteur (5) n'a dans l'ensemble aucun astigmatisme axial à six chiffres ($A_5$), que la distance des éléments multipôles (1 et 3) des lentilles rondes (7", 8") plus éloignées du plan de symétrie (6), correspond à la distance focale ($f'$) de ceux-ci en plus d'une autre distance ($\Delta z$), sachant que cette dernière est choisie de telle manière que pour les longueurs données $L$ et $L'$, l'erreur trilobée axiale de quatrième ordre ($D_4$) disparaît et que la longueur (L) de l'élément de multipôles central (2) est choisie par rapport aux longueurs ($L'$) des deux éléments de multipôles extérieurs identiques (1 et 3) de telle manière que l'erreur trilobée axiale de sixième ordre ($D_6$) disparaît pour le rapport prédéfini ($M = f / f'$) de la distance focale ($f$) des lentilles rondes (7', 8') plus proches du plan de symétrie (6) par rapport à la distance focale ($f'$) des lentilles rondes (7", 8") plus éloignées du plan de symétrie (6).

**2.** Correcteur selon la revendication 1,
**caractérisé en ce que**
le rapport (d) entre l'autre distance ($\Delta Z$) et les longueurs ($L'$) des éléments de multipôles extérieurs (1 et 3) est de 0,5 à 0,95 ($d = \frac{\Delta z}{L'} = 0,5$  0,5 à 0,95).

**3.** Correcteur selon la revendication 1 ou 2,
**caractérisé en ce que**
la puissance du champ d'hexapôles ($\Psi_{HP2}$) de l'élément multipôle central (2) par rapport à la puissance des champs d'hexapôles ($\Psi_{HP1,3}$) extérieurs (1,3) se situe de 0,33 à 1,7

$$\left( \frac{\Psi_{HP2}}{\Psi_{HP1,3}} = 0,33 \text{ à } 1,7 \right)$$

**4.** Correcteur selon l'une quelconque des revendications 1 à 3,
**caractérisé en ce que**

le rapport (*M*) entre les distances focales (*f*) des lentilles rondes (7', 8') situées plus près sur le plan de symétrie (6) et les distances focales (*f*) des lentilles rondes (7", 8") situées plus éloignées, donc *M* = *f* / *f'*, se situe dans une plage de 0,8 à 1,2.

5.  Correcteur selon la revendication 4,
    **caractérisé en ce que**

$$M = 1,15 \ (\pm \ 0,01).$$

6.  Correcteur selon l'une quelconque des revendications 1 à 5,
    **caractérisé en ce que**
    le rapport *(k)* entre la longueur (*L*) de l'élément de multipôles central (2) et la longueur (*L'*) des multipôles extérieurs (1 et 3), donc *k* = *L* / *L'*, se situe dans une plage de 2,0 à 3,5.

7.  Correcteur selon la revendication 6,
    **caractérisé en ce que**

$$k = 3,05 \ (\pm \ 0,05).$$

8.  Correcteur selon l'une quelconque des revendications 1 et 7,
    **caractérisé en ce que**
    les plans de symétrie (9" et 10") des doublets d'hexapôles (9, 9',10, 10') des lentilles rondes (7', 8'), disposés en plus entre les lentilles rondes (7', 7", 8', 8") des doublets de lentilles rondes (7, 8), sont disposés à une certaine distance de leurs distances focales (*f*) et des lentilles rondes (7" et 8") à une certaine distance de leurs distances focales (f'), sachant que les doublets d'hexapôles (9, 9', 10, 10') sont constitués et excités de telle manière qu'à l'intérieur du correcteur (5) de petites variations de l'erreur trilobée de quatrième ordre ($D_4$) peuvent être générées pour compenser des erreurs causées par défaut de conception.

9.  Correcteur selon l'une quelconque des revendications 1 et 8,
    **caractérisé en ce que**
    les plans de symétrie (9" et 10") des doublets d'hexapôles (9, 9',10, 10') des lentilles rondes (7', 8'), disposés en plus entre les lentilles rondes (7', 7", 8', 8") des doublets de lentilles rondes (7, 8), sont disposés à une certaine distance de leurs distance focales (f) et des lentilles rondes (7" et 8") à une certaine distance de leurs distances focales (f'), sachant que les doublets d'hexapôles (9, 9', 10, 10') sont constitués et excités de telle manière que de petites variations d'erreurs résiduelles, en particulier $D_6$, $A_5$, sont possibles, qui permettent à nouveau la compensation d'erreurs parasitaires ou qui permettent à nouveau la minimisation de l'effet d'erreurs d'ordre supérieur de multiplicité identique, en particulier $D_8$ et $G_7$.

10. Microscope électronique,
    **caractérisé en ce qu'**
    il est équipé d'un correcteur (5) selon l'une quelconque des revendications 1 à 9.

11. Microscope électronique selon la revendication 10,
    **caractérisé en ce qu'**
    il s'agit d'un microscope électronique à balayage (MEB).

12. Microscope électronique selon les revendications 10 et 11,
    **caractérisé en ce qu'**
    il s'agit d'un microscope électronique de transmission à balayage (METB).

13. Microscope électronique selon la revendication 10,
    **caractérisé en ce qu'**
    il s'agit d'un microscope électronique de transmission (MET) pour lequel le correcteur (5) est monté en aval eu égard à la trajectoire de faisceau de la lentille d'objectif (13) .

14. Microscope électronique selon l'une quelconque des revendications 10 à 13,

**caractérisé en ce qu'**
un système de lentilles de transfert (11) est inséré entre le correcteur (5) et la lentille d'objectif (13), avec lequel les défauts d'ouverture peuvent être corrigés.

15. Microscope électronique selon la revendication 14,
**caractérisé en ce que**
le système de lentilles de transfert (11) est composé d'une lentille de transfert.

16. Microscope électronique selon la revendication 14,
**caractérisé en ce que**
le système de lentilles de transfert (11) est composé de deux lentilles de transfert (11', 11").

17. Microscope électronique selon la revendication 16,
**caractérisé en ce que**
les lentilles de transfert (11', 11") comportent différentes distances focales ($f''$, $f'''$) de telle sorte qu'avec celles-ci, il est possible d'éliminer les erreurs d'ouverture de lentille d'objectif.

18. Microscope électronique selon la revendication 17,
**caractérisé en ce que**
les distances focales ($f''$, $f'''$) des lentilles de transfert (11', 11") peuvent être réglées au moyen de l'excitation des bobines des lentilles de transfert (11', 11") pour éliminer les erreurs concrètes d'ouverture de lentille d'objectif.

Fig.1

EP 3 780 064 B1

$c(D_6)$

$a(A_2 \text{ und } D_4)$

$b(A_5)$

## Fig.2a

$b(A_5)$

$c(D_6)$

$a(A_2 \text{ und } D_4)$

## Fig.2b

$a(A_2 \text{ und } D_4)$

$b(A_5)$

## Fig.2c

Fig. 3b

Fig. 3a

Fig. 3d

Fig. 3c

Fig. 3e

Fig. 3g

Fig. 3f

22

EP 3 780 064 B1

103 mrad
150 mrad

Fig. 3i

76 mrad
150 mrad

Fig. 3h

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0451370 B1, Rose
- EP 3255649 A1
- DE 102006017686 A1
- EP 2325862 A1
- EP 2325863 B1

**In der Beschreibung aufgeführte Nicht-Patentliteratur**

- **ROLF ERNI.** *Aberration-Corrected Imaging in Transmission Electron Microscopy - An Introduction,* 2010, 222, , 224, , 225
- **O. SCHERZER.** Sphärische und chromatische Korrektur von Elektronen-Linsen. *OPTIK, DE, JENA,* 1947, ISSN 0863-0259, 114-132
- **MÜLLER H. ; UHLEMANN S. ; HARTEL P. ; HAIDER M.** Advancing the Hexapole Cs-corrector for the scanning transmission electron microscope. *Microsc. Microanal.,* 2006, vol. 12, 442-455
- **SAWADA.** Correction of higher order geometrical aberration by triple 3-fold astigmatism field. *Journal of Electron Microscopy,* 2009, vol. 58 (6), 341-347
- **MORISHITA.** Evaluation of residual aberration in fifth-order geometrical aberration correctors. *Mircroscopy,* 2018, 156-163
- **R. ERNIE.** *Aberration-Corrected Imaging in Transmission Elektron Microscopy,* 2010, 48